# FASCICULE DE BREVET EUROPEEN

(11) **EP 0 642 699 B1**
(45) Date de publication et mention de la délivrance du brevet: **07.11.2007**
(21) Numéro de dépôt: 93913073.8
(22) Date de dépôt: 26.05.1993
(51) Int. Cl.: H01L 23/52, H01L 21/60, H01L 23/49, H01L 23/522

(54) **PROCEDE DE FABRICATION D'UN DISPOSITIF A SEMI-CONDUCTEURS COMPORTANT AU MOINS UNE PUCE, ET DISPOSITIF CORRESPONDANT**
VERFAHREN ZUR HERSTELLUNG EINES HALBLEITERBAUELEMENTS MIT MINDESTENS EINEM CHIP UND ENTSPRECHENDES BAUELEMENT.
PROCESS FOR THE MANUFACTURE OF A SOLID-STATE DEVICE INCLUDING AT LEAST ONE CHIP, AND CORRESPONDING DEVICE

(30) Priorité: 27.05.1992 FR 9206518
(43) Date de publication de la demande: 15.03.1995
(73) Titulaire: Tronic's Microsystems, 38054 Grenoble (FR); ELA MEDICAL, F-92120 Montrouge (FR)
(72) Inventeur: VAL, Christian, F-92402 Courbevoie Cédex (FR); VAN CAMPENHOUT, Yves, F-92402 Courbevoie Cédex (FR); GILET, Dominique, F-92402 Courbevoie Cédex (FR)
(74) Mandataire: Benoit, Monique
(86) Numéro de dépôt international: PCT/FR1993/000513
(87) Numéro de publication internationale: WO 1993/024956

(56) Documents cités:
- EP-A- 0 448 276
- EP-A2- 0 448 276
- WO-A-88/09599
- WO-A2-88/09599
- FR-A- 2 622 741
- GB-A- 2 092 376
- PATENT ABSTRACTS OF JAPAN vol. 7, no. 186 (E-193) 16 Août 1983 & JP-A-58 091 649 ( TOKYO SHIBAURA DENKI KK ) 31 Mai 1983
- PATENT ABSTRACTS OF JAPAN vol. 7, no. 186 (E-193), 16 août 1983 (1983-08-16) & JP 58 091649 A (TOKIO SHIBAURA DENKI KK), 31 mai 1983 (1983-05-31)

## Description

L'invention est relative à un procédé de fabrication d'un dispositif à semi-conducteurs comportant au moins une puce, et au dispositif correspondant.

Les procédés connus de fabrication de dispositifs à semi-conducteurs peuvent être classés en trois catégories :
a) des procédés individuels couramment appelés "die bonding" de liaison électrique séquentielle par soudures de fils métalliques d'or ou d'aluminium entre une puce ("chip") et des broches électriques de connexion.
   Après réalisation des liaisons électriques par fils ("lead") métalliques, la puce disposée sur un support est encapsulée dans une matière plastique, ou ce support est complété pour obtenir une herméticité.
   Les dispositifs obtenus par ces procédés industriellement fiables présentent toutefois l'inconvénient d'occuper une surface importante et un volume plus de dix fois supérieur à celui de la puce que le dispositif comporte ;
b) des procédés de fabrication en série par technique de report sur bande ("TAB" ou "tape automated bonding"), tels que décrits de façon extensive dans l'article "TAB Implementation and Trends", par Paul HOFFMANN - Mesa Technology, Mountain view, CA - pages 85 à 88 du périodique "Solid State Technology" de Juin 1988.
   La teneur de cet article est considérée comme incorporée dans la présente description.
   Ces procédés dont la productivité est supérieure à celle des procédés individuels permettent avantageusement de tester les puces avant l'assemblage final, mais présentent l'inconvénient de nécessiter un traitement spécial des plaquettes de silicium et également d'occuper une surface importante ;
c) des procédés de liaison électrique entre une puce et des broches de connexion, par fusion de microbilles métalliques : ces procédés connus sous le nom de "flip chip » présentent l'inconvénient de nécessiter un traitement spécial des plaquettes de silicium, sont difficiles à mettre en oeuvre de façon fiable lorsque le support de connexion et la puce présentent des coefficients de dilatation thermique différents. Le contrôle des soudures correspondantes est complexe et difficile à effectuer.

De plus, les équipements de fabrication correspondants sont spécifiques et peu répandus ; le coût de ce type d'équipement entraîne un coût élevé des dispositifs à semi-conducteurs fabriqués par ce procédé.

Un autre procédé connu est décrit dans la demande de brevet français FR-A-2 622 741. Ce procédé concerne la connexion d'une microplaquette de semi-conducteur à un support multicouches au moyen de microbroches soudées dont le rôle est de réduire les contraintes liées à la différence de coefficient de dilatation thermique entre la microplaquette et le support. La mise en oeuvre est délicate et le dispositif obtenu présente une certaine fragilité.

L'invention a pour but de créer un nouveau procédé de fabrication apte à être mis en oeuvre au moyen des équipements de fabrication existants, de manière à fabriquer des dispositifs de taille minimale, facilement testables et contrôlables visuellement, aptes à être insérés dans des dispositifs électroniques où la réduction de taille est primordiale comme, par exemple, les stimulateurs cardiaques.

L'invention a pour objet un procédé de fabrication de dispositif à semi-conducteurs tel que défini par la revendication 1.

Selon d'autres caractéristiques de l'invention
- après l'étape de revêtement de matériau thermostable et électriquement isolant et avant l'étape de métallisation, on trace un sillon en forme de V sur le matériau électriquement isolant et thermostable à l'emplacement des chemins de découpe des puces :

- on effectue te revêtement de matériau électriquement isolant et thermostable de manière à définir des pattes à l'endroit des fils métalliques.

L'invention a également pour objet un dispositif à semi-conducteurs tel que défini par la revendication 6.

Selon d'autres caractéristiques de l'invention:
- les plots métallisés sont situés à des endroits correspondant à des pattes en saillie sur la face du dispositif ;
- les plots métallisés comportent un pan incliné facilitant l'inspection visuelle ;
- la puce forme le support du dispositif ;
- le support du dispositif est un circuit multicouches comportant des métallisations ;
- le support multicouches est relié à au moins une puce, et le support est revêtu au moins du côté de la puce par une épaisseur de matériau électriquement isolant et thermostable correspondant à l'isolation électrique du support et formant le revêtement en matériau électriquement isolant de la puce, ledit matériau électriquement isolant et thermostable étant traversé par au moins un fil métallique de connexion ;
- le dispositif comporte au moins une résistance déposée à une interface entre deux couches adjacentes.

L'invention sera mieux comprise grâce à la description qui va suivre donnée à titre d'exemple non limitatif au regard des dessins annexés dans lesquels:
- la figure 1 représente schématiquement une vue de dessus d'une plaquette ou substrat de silicium selon l'invention ;
- la figure 2 représente schématiquement une vue latérale dans le sens de la flèche II de la figure 1 d'une plaquette selon l'invention ;
- la figure 3 représente schématiquement une vue partielle agrandie de dessus selon la repère III de la figure 1 ;
- la figure 4 représente schématiquement une vue partielle en coupe transversale selon la ligne IV-IV de la figure ;
- les figure 5 et 6 réprésentent schématiquement des vues partielles agrandies respectivement selon les repères V et VI de la figure 4 ;
- les figures 7, 8 et 9 représentent schématiquement des vues analogues respectivement aux figures 4, 5 et 6 d'un autre mode de réalisation de l'invention ;
- la figure 10 représente schématiquement une vue en coupe transversale analogue aux figures 4 et 7 d'un troisième mode de réalisation de l'invention.
- les figures 11 et 12 représentent schématiquement une vue en perspective et une section partielle en coupe transversale d'un quatrième mode de réalisation de l'invention.
- les figures 13A et 13B représentent schématiquement en coupe transversale deux autres variantes de réalisation de l'invention.

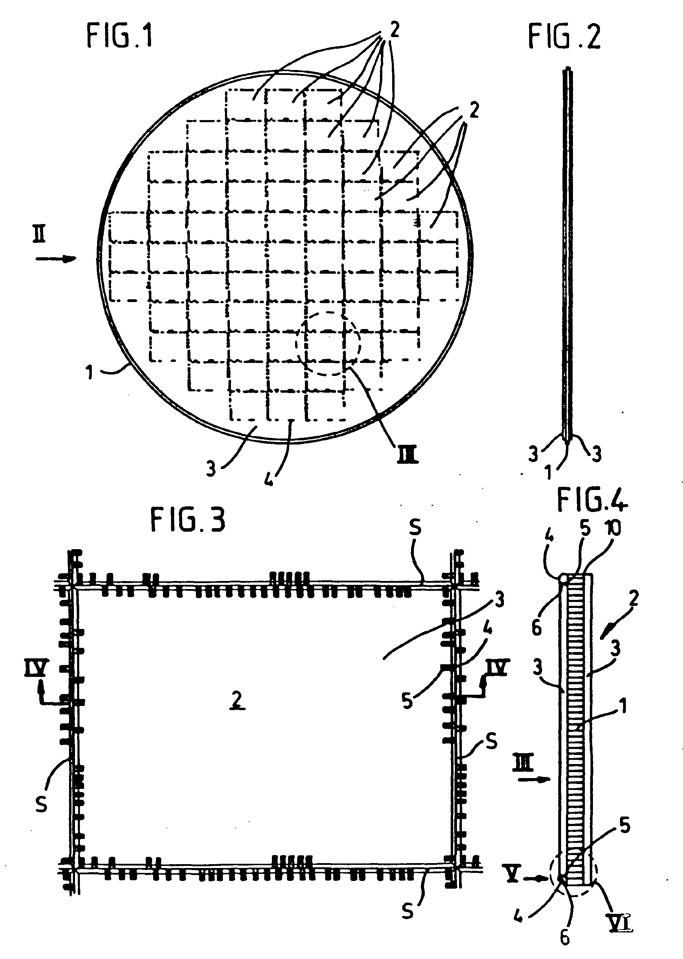

En référence aux figures 1 et 2, on a réalisé sur un substrat 1 par exemple en silicium monocristallin un ensemble de puces 2 ("chips") au moyen de techniques connues de photolitographie et de déposition de couches successives.

Sur le substrat 1, on a déposé sur au moins une face un matériau 3 électriquement isolant et de préférence thermostable, selon une épaisseur apte à assurer l'isolation électrique entre le substrat et des plots métallisés 4 à la surface dudit matériau thermostable.

Les matériaux thermostables utilisables à cet effet sont des matériaux de propriétés analogues à celles de polyimides, par exemple des polyimides, des polyphénylquinoxalines, des polysiloxanes, des résines époxy ou analogue. Ces matériaux sont de préférence déposés par enrobage ou un procédé équivalent ; leur épaisseur est ensuite réglée par exemple par polissage ou meulage à une valeur comprise entre 0,05 mm et plusieurs mm.

De préférence, lorsque le substrat 1 est d'épaisseur faible, on déposera le matériau thermostable 3 sur les deux faces de substrat selon des épaisseurs suffisantes (de l'ordre de 0,5 mm par exemple) pour éviter le voilage du substrat et conserver une bonne planéité, un bon parallélisme et un bon état de surface des faces extérieures.

Dans l'exemple des figures 3 à 6, le procédé selon l'invention comporte les étapes suivantes :
- réaliser sur un substrat 1 un ensemble de puces 2 par des opérations de traitement connues, de manière à constituer des emplacements de connexion 5 (par exemple de forme carrée) sur une surface accessible des puces 2 du substrat 1 ;
- effectuer un contrôle électrique séquentiel ("test") des puces 2 réalisées ;
- effectuer un contrôle visuel au moyen d'appareils connus des puces 2 réalisées ;
- effectuer un raccordement sur la puce 2 à l'emplacement de carrés de connexion 5 par fusion ultrasonique d'extrémités de fils métalliques 6 et soudage par écrasement de la goutte 7 d'extrémité sur un carré 5 métallisé correspondant.

Cette étape est similaire au câblage de queues métalliques sur puce ("chip") connu sous le nom de "Bonded Interconnect Pin" (ou "BIP", BIP est une marque déposée), décrit dans l'article "Next Generation Technologies", extrait de l'ouvrage "High performance packaging solutions", pages 10-6 à 10-8, publié en 1991 par "Integrated Circuit Engineering Corporation", ISBN 1-87 77 50-10-7. La teneur de cet article est considérée comme incorporée dans la présente description.
- effectuer la mise à longueur des fils métalliques 6 par coupage à une longueur d'un ou plusieurs mm, les dits fils coupés se dressant sensiblement perpendiculairement aux emplacements 5 des puces 2.
- enrober avec un matériau thermostable 3 du genre résine polyimide ou résine époxy au moins la face du substrat 1 portant les queues métalliques 6 ;
- rectifier au moins la face précitée (portant les queues métalliques 6) de préférence par meulage ou polissage selon l'épaisseur désirée de résine 3 supérieure à 0,05 mm, de manière à obtenir une bonne planéité et un bon parallélisme des faces ;
- tracer des sillons 7 sensiblement en forme de V sur la résine 3 le long des chemins de découpe des puces 2, la profondeur des sillons 7 étant de préférence inférieure à la moitié de l'épaisseur de résine 3 rectifiée ;
- effectuer de manière connue une métallisation au moins sur la face dont émergent les extrémités des queues métalliques 6 par un procédé connu de photolithographie, de manière à relier les queues métalliques 6 à des plots métallisés 4 de connexion électrique.

Cette étape de métallisation peut être effectuée par projection ("sputtering"), électrodéposition ("electroplating") d'un revêtement de métal contenant un ou plusieurs éléments du type cuivre (Cu), nickel (Ni), or (Au) ou analogue selon une épaisseur comprise de préférence entre 5 micromètres et 150 micromètres.
- effectuer un contrôle électrique séquentiel ("test") des puces 2 au moyen des plots métallisés 4 ;
- découper suivant les chemins de découpe au fond des sillons 7, de manière à obtenir des puces individuelles 2.

Grâce au procédé selon l'invention, on obtient après métallisation des pans inclinés 9, aptes à être inspectés visuellement même après fixation de la puce selon l'invention sur un circuit.

Les pans inclinés 9 faisant partie des plots métallisés 4 sont de préférence de largeur comparable avec la largeur des faces planes 8 des plots 4 et inclinés par rapport à celles-ci selon un angle A compris entre 30° et 60°, de préférence de l'ordre de 45°.

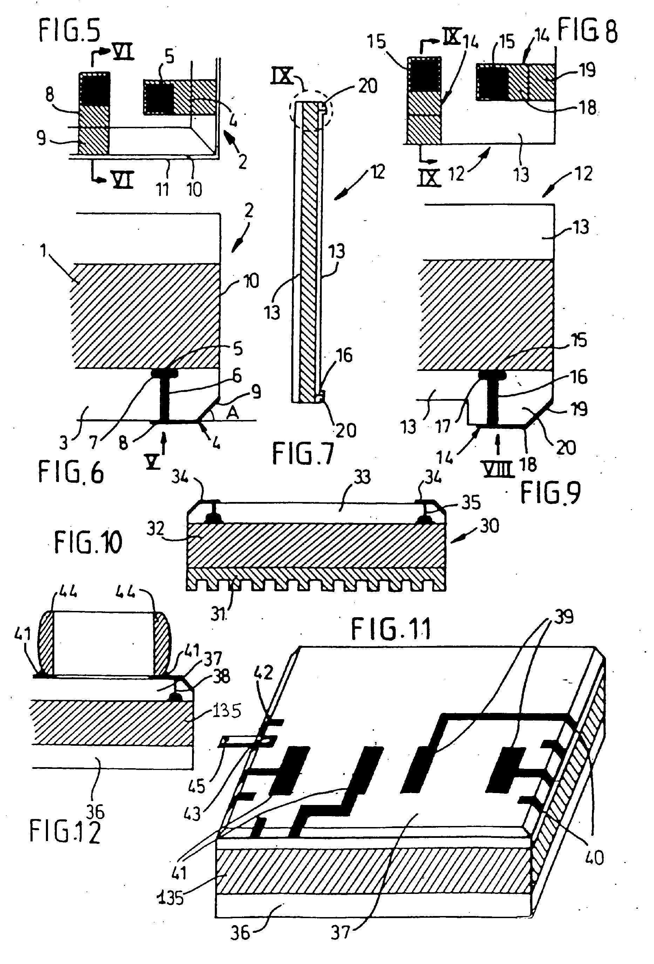

Dans certaines applications, on prévoit de protéger la tranche 10 de la puce 2 par un revêtement 11 représenté uniquement sur la figure 5 de matière isolante et chimiquement neutre, du type silice ou résine isolante analogue, telle qu'un polyimide de préférence apte à être déposé par photolithographie ("photoimageable"), ou simplement par trempage dans un bain de résine liquide après protection au moins de la face portant les plots métallisés 4.

En référence aux figures 7 à 9, une puce est réalisée de manière analogue à la puce 2 des figures 4 à 5 et comprend des revêtements en matériau 13, des plots 14 reliés à des emplacements 15 au moyen de fils métalliques 16 terminés par des gouttes écrasées 17.

De préférence, la superficie d'un emplacement 15 est supérieure à 1600 micromètres carrés (40 µm X 40 µm) et la section d'un fil 16 est de l'ordre de 400 micromètres carrés.

Dans ce deuxième mode de réalisation, les plots métallisés 14 sont déposés sur une partie des surfaces extérieures planes 18 et inclinées 19 de pattes 20 individuelles en résine ou matériau thermostable analogue. Les pattes 20 subsistent après rectification mécanique ou dépôt photolithographique aux endroits désirés : ces pattes 20 présentent l'avantage de permettre le nettoyage sous la face de la puce 12 reliée électriquement à un circuit en étant fixée sur un support.

En référence à la figure 10, un dispositif 30 comporte un revêtement 31 formant radiateur thermique, par exemple en métal, fixé sur un circuit intégré 32 formant substrat et revêtu d'un matériau 33 thermostable et électriquement isolant.

Le matériau 33 de revêtement est traversé par des fils électriquement conducteurs 35 (par exemple en or ou en aluminium) de liaison avec des surfaces métallisées 34 de connexion électrique : les fils précités sont sensiblement perpendiculaires aux surfaces métallisées 34.

En référence aux figures 11 et 12, une puce 135 formant substrat est revêtu d'un matériau 36 du genre polyimide sur la face non active.

La face opposée de la puce 135 est en liaison à travers un revêtement 37 au moyen de fils 38 électriquement conducteurs avec des surfaces métallisées 39, 40, 41, 42, 43. Les fils 38 sont sensiblement perpendiculaires à la fois à la face de la puce 35 et aux surfaces métallisées 39 à 43.

Sur les surfaces 41 sensiblement rectangulaires on brase ou on colle au moyen d'une colle électriquement conductrice un composant passif comportant deux extrémités opposées 44 métallisées.

Sur la surface métallisée 43, on fixe de manière analogue une broche de connexion 45 de préférence en métal.

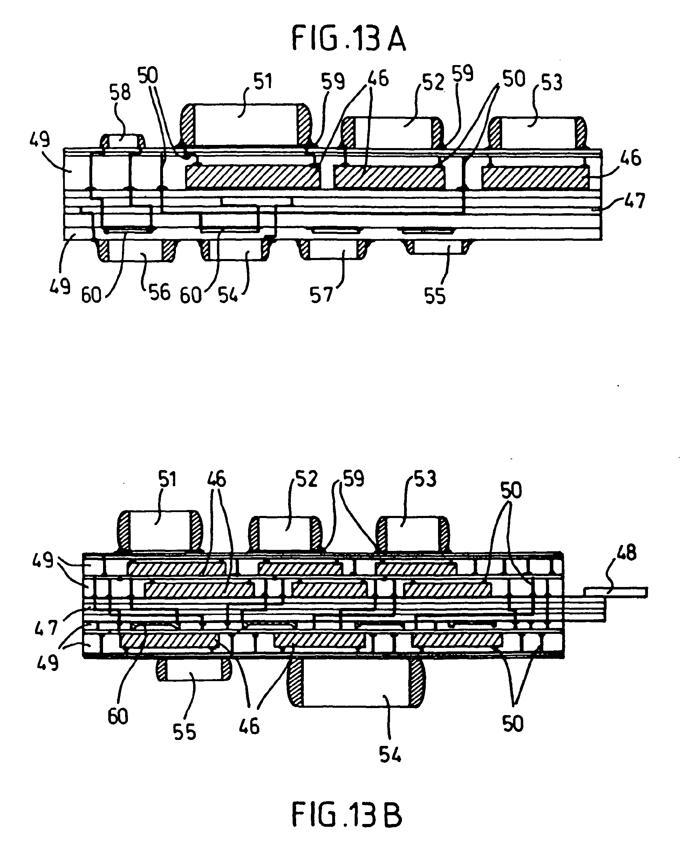

En référence aux figures 13A et 13B, on réalise des dispositifs à couches- multiples comportant des puces 46 fixées sur au moins un support multicouches 47 sur une seule face (fig 13A) ou sur les deux faces (fig 13B).

Le support multicouches 47 est un support de type connu, par exemple en silicium (Si), en céramique (pellicules minces à pourcentage d'alumine (Al₂ O₃) comprise entre 96 et 99,5%), en carbure de silicium, en nitrure d'aluminium, en cocuit céramique haute température, en cocuit céramique basse température, en verre ou en céramique-vitreuse à 55% d'alumine.

Ce support 47 éventuellement relié à des pattes de connexion 48, est revêtu d'un matériau thermostable 49 au moins sur une face.

Le matériau thermostable 49 est traversé par des fils métalliques 50 (par exemple en or ou en aluminium) de liaison avec d'autres puces 46, des composants de surface 51, 52, 53, 54, 55, 56, 57, 58.

Les composants électroniques 51 à 58 sont des composants actifs ou passifs comportant de préférence des extrémités métallisées aptes à être reliées électriquement aux surfaces métallisées 59 des faces extérieures.

On prévoit avantageusement de déposer des résistances 60 de type connu (par exemple sérigraphiées ou électrodéposées), sur le support multicouches ou entre deux couches, ce qui assure une compacité maximale des dispositifs selon l'invention et une section correspondant à la section du support 47.

## Revendications

1. Procédé de fabrication de dispositif à semi-conducteurs comportant au moins une puce (2) ayant sur une face accessible sensiblement plane des emplacements (5) de connexion électrique ; le procédé comportant les étapes suivantes :
• effectuer un raccordement par soudage de fils métalliques (6) sur des emplacements (5) de la puce (2) selon une direction sensiblement perpendiculaire à ladite face sensiblement plane de la puce ;
• effectuer sur ladite face un revêtement de matériau électriquement isolant (3) selon une épaisseur correspondant à l'isolation électrique de la puce (2), le matériau électriquement isolant étant un matériau thermostable, de propriétés analogues à celles des polyimides, d'épaisseur supérieure à 0,05 mm;
• effectuer une métallisation de surface sur ledit revêtement (3) selon un dessin définissant des plots métallisés (4, 14, 39, 40, 41, 42, 43) reliés électriquement aux fils métalliques (6).

2. Procédé selon la revendication 1, **caractérisé en ce que** ledit matériau thermostable électriquement isolant fait partie des polyimides, polyphénylquinoxalines, polysiloxanes, résines époxy ou analogue.

3. Procédé selon l'une des revendications 1 ou 2, dans lequel la puce (2) est réalisée sur un substrat (1), **caractérisé en ce que**, après l'étape de revêtement de matériau électriquement isolant et avant l'étape de métallisation, on trace un sillon (S) en forme de V sur le matériau électriquement isolant (3) à l'emplacement des chemins de découpe des puces (2).

4. Procédé selon l'une des revendications 1 à 3, **caractérisé en ce qu'**on effectue le revêtement de matériau électriquement isolant (3) de manière à définir des pattes (20) à l'endroit des fils métalliques (6).

5. Procédé selon l'une des revendications 1 à 4, **caractérisé en ce que** l'étape de métallisation consiste en un dépôt métallique et une photolithographie.

6. Dispositif à semi-conducteurs comportant au moins une puce, dans lequel la puce (2, 12) est revêtue d'un matériau thermostable électriquement isolant (3, 13), le matériau électriquement isolant (3, 13) est traversé par des fils de connexion (6, 16) électrique reliant des emplacements (5, 15) de connexion électrique de la puce à des plots métallisés (4, 14) sur une face dudit matériau opposée à ladite puce et en ce que les fils (6, 16) sont sensiblement perpendiculaires à la fois auxdits emplacements (5, 15) et auxdits plots métallisés (4, 14), **caractérisé en ce que** le le matériau thermostable électriquement isolant est un matériau de propriétés analogues à celles des polyimides, d'épaisseur supérieure à 0,05 mm.

7. Dispositif selon la revendication 6, **caractérisé en ce que** ledit matériau thermostable électriquement isolant fait partie des polyimides, polyphénylquinoxalines, polysiloxanes, résines époxy ou analogue.

8. Dispositif selon l'une des revendications 6 ou 7, **caractérisé en ce que** les plots métallisés (4) sont situés à des endroits correspondant à des pattes (20) en saillie sur la face du dispositif.

9. Dispositif selon l'une des revendications 6 à 8, **caractérisé en ce que** les plots métallisés (4, 14) comportent un plan incliné (9, 19) facilitant l'inspection visuelle.

10. Dispositif selon l'une des revendications 6 à 9, **caractérisé en ce que** la puce (2) forme support pour le dispositif.

11. Dispositif selon l'une des revendications 6 à 9, **caractérisé en ce que** le dispositif comporte un support constitué par un circuit multicouche (47) comportant des métallisations, **en ce que** le support multicouche (47) est relié à au moins une puce (46), et **en ce que** le support est revêtu au moins du côté de la puce (46) par une épaisseur de matériau électriquement isolant (49) correspondant à l'isolant électrique du support (47) et formant le revêtement en matériau électriquement isolant de la puce (46), ledit matériau électriquement isolant (49) étant traversé par au moins un fil métallique (50) de connexion.

12. Dispositif selon la revendication 11, **caractérisé en ce que** le dispositif comporte au moins une résistance déposée (60) à une interface entre deux couches adjacentes.

## Claims

1. Process for fabricating a semiconductor device, comprising at least one chip (2) having, on a substantially planar accessible face, electrical connection areas (5), the process comprising the following steps:
• metal wires (6) are connected by bonding to areas (5) of the chip (2) in a direction substantially perpendicular to said substantially planar face of the chip;
• a coating of electrically insulating material (3) is deposited on said face with a thickness corresponding to the electrical isolation of the chip (2), the electrically insulating material being a heat-stable material, with properties similar to those of polyimides, with a thickness of greater than 0.05 mm; and
• a surface metallization operation is carried out on said coating (3) in a pattern defining metallized pads (4, 14, 39, 40, 41, 42, 43) electrically connected to the metal wires (6).

2. Process according to Claim 1, **characterized in that** said electrically insulating heat-stable material is among polyimides, polyphenylquinoxalines, polysiloxanes, epoxy resins or the like.

3. Process according to either of Claims 1 and 2, in which the chip (2) is produced on a substrate (1), **characterized in that**, after the step of coating with the electrically insulating material and before the metallization step, a V-shaped groove (S) is scored on the electrically insulating material (3) at the location of the paths for dicing the chips (2).

4. Process according to one of Claims 1 to 3, **characterized in that** the coating with electrically insulating material (3) is carried out so as to define leads (20) at the place of the metal wires (6).

5. Process according to one of Claims 1 to 4, **characterized in that** the metallization step consists of metal deposition and photolithography.

6. Semiconductor device comprising at least one chip, in which the chip (2, 12) is coated with an electrically insulating heat-stable material (3, 13), electrical connection wires (6, 16) pass through the electrically insulating material (3, 13), said wires connecting electrical connection areas (5, 15) of the chip to metallized pads (4, 14) on the opposite face of said material from said chip, and the wires (6, 16) are substantially perpendicular both to said areas (5, 15) and to said metallized pads (4, 14), **characterized in that** the electrically insulating heat-stable material is a material having properties similar to those of polyimides, with a thickness of greater than 0.05 mm.

7. Device according to Claim 6, **characterized in that** said electrically insulating heat-stable material is among polyimides, polyphenylquinoxalines, polysiloxanes, epoxy resins or the like.

8. Device according to either of Claims 6 and 7, **characterized in that** the metallized pads (4) are located at places corresponding to projecting leads (20) on the face of the device.

9. Device according to one of Claims 6 to 8, **characterized in that** the metallized pads (4, 14) include an inclined plane (9, 19) making visual inspection easier.

10. Device according to one of Claims 6 to 9, **characterized in that** the chip (2) forms a support for the device.

11. Device according to one of Claims 6 to 9, **characterized in that** the device includes a support consisting of a multilayer circuit (47) having metallizations, **in that** the multilayer support (47) is connected to at least one chip (46) and **in that** the support is coated at least on the side of the chip (46) with a thickness of electrically insulating material (49) corresponding to the electrical insulator of the support (47) and forming the coating of electrically insulating material of the chip (46), at least one metal connection wire (50) passing through said electrically insulating material (49).

12. Device according to Claim 11, **characterized in that** the device includes at least one resistor (60) deposited at an interface between two adjacent layers.

## Patentansprüche

1. Verfahren zum Herstellen einer Halbleitervorrichtung, die wenigstens einen Chip (2) enthält, der auf einer im Wesentlichen ebenen Zugangsfläche elektrische Anschlussstellen (5) besitzt; wobei das Verfahren die folgenden Schritte enthält:
- Herstellen einer Verbindung durch Anlöten von metallischen Drähten (6) an die Stellen (5) des Chips (2) in einer zu der im Wesentlichen ebenen Fläche des Chips im Wesentlichen senkrechten Richtung;
- Herstellen auf der Fläche einer Beschichtung aus einem elektrisch isolierenden Material (3) mit einer Dicke, die der elektrischen Isolation des Chips (2) entspricht, wobei das elektrisch isolierende Material ein thermostabiles Material mit Eigenschaften, die zu jenen von Polyimiden analog sind, und mit einer Dicke von mehr als 0,05 mm ist;
- Herstellen einer Oberflächenmetallisierung auf der Beschichtung (3) nach einem Muster, das metallisierte Kontaktflächen (4, 14, 39, 40, 41, 42, 43) definiert, die mit den metallischen Drähten (6) elektrisch verbunden sind.

2. Verfahren nach Anspruch 1, **dadurch gekennzeichnet, dass** das elektrisch isolierende, thermostabile Material zu den Polyimiden, Polyphenylchinoxalinen, Polysiloxanen, Epoxidharzen oder dergleichen gehört.

3. Verfahren nach einem der Ansprüche 1 oder 2, bei dem der Chip (2) auf einem Substrat (1) hergestellt ist, **dadurch gekennzeichnet, dass** nach dem Schritt des Beschichtens mit einem elektrisch isolierenden Material und vor dem Schritt der Metallisierung am Ort der Schnittlinien der Chips (2) eine V-förmige Furche (S) in dem elektrisch isolierenden Material (3) gezogen wird.

4. Verfahren nach einem der Ansprüche 1 bis 3, **dadurch gekennzeichnet, dass** die Beschichtung aus elektrisch isolierendem Material (3) in der Weise hergestellt wird, dass am Ort der metallischen Drähte (6) Ansätze (20) definiert werden.

5. Verfahren nach einem der Ansprüche 1 bis 4, **dadurch gekennzeichnet, dass** der Metallisierungsschritt aus einer Metallablagerung und aus einer Photolithographie besteht.

6. Halbleitervorrichtung, die wenigstens einen Chip enthält, wobei der Chip (2, 12) mit einem elektrisch isolierenden, thermostabilen Material (3, 13) beschichtet ist, wobei durch das elektrisch isolierende Material (3, 13) Drähte (6, 16) für eine elektrische Verbindung verlaufen, die elektrische Anschlussstellen (5, 15) des Chips mit metallisierten Kontaktflächen (4, 14) auf einer Fläche des Materials gegenüber dem Chip verbinden, und wobei die Drähte (6, 16) sowohl zu den Stellen (5, 15) als auch zu den metallisierten Kontaktflächen (4, 14) im Wesentlichen senkrecht sind, **dadurch gekennzeichnet, dass** das elektrisch isolierende, thermostabile Material ein Material mit Eigenschaften, die zu jenen der Polyimide analog sind, und mit einer Dicke von mehr als 0,05 mm ist.

7. Vorrichtung nach Anspruch 6, **dadurch gekennzeichnet, dass** das elektrisch isolierende, thermostabile Material zu den Polyimiden, Polyphenylchinoxalinen, Polysiloxanen, Epoxidharzen oder dergleichen gehört.

8. Vorrichtung nach einem der Ansprüche 6 oder 7, **dadurch gekennzeichnet, dass** sich die metallisierten Kontaktflächen (4) an Orten befinden, die vorstehenden Ansätzen (20) auf der Fläche der Vorrichtung entsprechen.

9. Vorrichtung nach einem der Ansprüche 6 bis 8, **dadurch gekennzeichnet, dass** die metallisierten Kontaktflächen (4, 14) eine geneigte Ebene (9, 19) aufweisen, die die visuelle Untersuchung erleichtert.

10. Vorrichtung nach einem der Ansprüche 6 bis 9, **dadurch gekennzeichnet, dass** der Chip (2) einen Träger für die Vorrichtung bildet.

11. Vorrichtung nach einem der Ansprüche 6 bis 9, **dadurch gekennzeichnet, dass** die Vorrichtung einen Träger aufweist, der durch eine Mehrschichtschaltung (47) gebildet ist, die Metallisierungen enthält, dass der Mehrschichtträger (47) mit wenigstens einem Chip (46) verbunden ist und dass der Träger zumindest auf Seiten des Chips (46) mit dem elektrisch isolierenden Material (49) beschichtet ist, das eine Dicke besitzt, die der elektrischen Isolation des Trägers (47) entspricht, und die Beschichtung aus einem elektrisch isolierenden Material des Chips (46) bildet, wobei durch das elektrisch isolierende Material (49) wenigstens ein metallischer Anschlussdraht (50) verläuft.

12. Vorrichtung nach Anspruch 11, **dadurch gekennzeichnet, dass** die Vorrichtung wenigstens einen ohmschen Widerstand (60) aufweist, der an einer Grenzfläche zwischen zwei benachbarten Schichten aufgebracht ist.
